# EUROPEAN PATENT APPLICATION

(11) **EP 2 743 714 A1**
(43) Date of publication of application: **18.06.2014**
(21) Application number: 12836810.7
(22) Date of filing: 27.09.2012
(51) Int. Cl.: G01R 33/04

(54) **COIL WIRING ELEMENT AND METHOD FOR MANUFACTURING COIL WIRING ELEMENT**

(30) Priority: 28.09.2011 JP 2011211749
(71) Applicant: Fujikura Ltd., Tokyo 135-8512 (JP)
(72) Inventor: CHIBA Yasuto, Sakura-shi Chiba 285-8550 (JP)
(74) Representative: Cabinet Plasseraud
(86) International application number: PCT/JP2012/074829
(87) International publication number: WO 2013/047637

(57) **Abstract**

A coil wiring element of the invention includes: a plurality of first wirings (3) that are formed above a substrate (1) and have a center portion (3a) and both end portions (3b); a second resin portion (2) that is formed above the substrate (1) and support both end portions (3b) of each of the first wirings (3); a first resin portion (4) that covers the center portion (3a) of each of the first wirings (3); a plurality of second wirings (6) that are formed above the first resin portion (4) and have both end portions (6b); connecting portions (W) that connect the first wirings (3) to the second wirings (6) and are supported by the second resin portion (2); and a coil wiring in which both end portions (3b) of the first wirings (3) are connected to both end portions (6b) of the second wirings (6) in series, the coil wiring being wound around the first resin portion (4) in a spiral shape.

## Description

### TECHNICAL FIELD

The present invention relates to a coil wiring element and a method of manufacturing a coil wiring element. Particularly, the present invention relates to a coil wiring element that is configured so that a conductor layer and an insulating layer are stacked in layers above a substrate, and a coil wiring element manufacturing method using a thin-film processing.

This application claims priority from Japanese Patent Application No. 2011-211749 filed on September, 28, 2011, the contents of which are incorporated herein by reference in their entirety.

### BACKGROUND ART

During recent years, a triaxial electronic compass including a triaxial magnetic sensor combined therewith has been beginning to be mounted on not only a portable navigation device but also a portable telephone, a game controller, or the like.

Specifically, in applications for a navigation system, since information of the direction as well as position information is necessary, a magnetic sensor element used to detect geomagnetism is used.

As a magnetic sensor element capable of detecting geomagnetism, a magneto-impedance element, a flux gate element, or the like is known.

Such elements include a solenoidal coil configuration in which a coil that generates electromotive force depending on variation in an external magnetic field is wound around a magnetic core.

In order to reduce the size and the thickness of a magnetic sensor element in accordance with reduction in size and thickness of a portable appliance or the like, a thin-film processing (semiconductor process) is used.

A magnetic element of Patent Document 1 serving as a conventional flux-gate magnetic sensor element includes a constitution in which a first wiring layer that has a plurality of line-shaped conductor patterns, an insulating layer that leaves both end portions the line-shaped conductor pattern and covers the other portions thereof, and a second wiring layer that has a plurality of line-shaped conductor patterns that are connected to both end portions of the insulating layer are stacked in layers on a substrate in order.

The coil that is included in the magnetic sensor element is configured so that both end portions of the linear pattern of the first wiring layer are connected to both end portions of the linear pattern of the second wiring layer.

At this time, the first wiring layer is formed on the substrate, a resin layer that is interposed between the substrate and the first wiring layer does not exist.

### PRIOR ART DOCUMENTS

### PATENT DOCUMENTS

[Patent Document 1]Japanese Unexamined Patent Application, First Publication No. H07-191118

### SUMMARY OF INVENTION

### PROBLEMS TO BE SOLVED BY THE INVENTION

A coil wiring element that is used in a conventional magnetic sensor element has the following problems.

In a process of forming a conventional coil wiring element, firstly, a first wiring layer is formed on a substrate; thereafter, a second wiring layer is formed with an insulating layer interposed therebetween, and the first wiring layer is connected to the second wiring layer at both end portions thereof.

At this time, if the top surface of the first wiring layer is not clean or a metal-oxide layer is formed thereon, the first wiring layer cannot be firmly connected to the second wiring layer.

For this reason, when the coil wiring element is thermally-deformed or drop impact is applied to the coil wiring element, there is a possibility that the first wiring layer is peeled off from the second wiring layer and electrical connection is lost.

In a conventional magnetic sensor element, the connecting portion at which the first wiring layer is connected to the second wiring layer is a portion to which stress is particularly likely to be concentrated, there is a structural weak point.

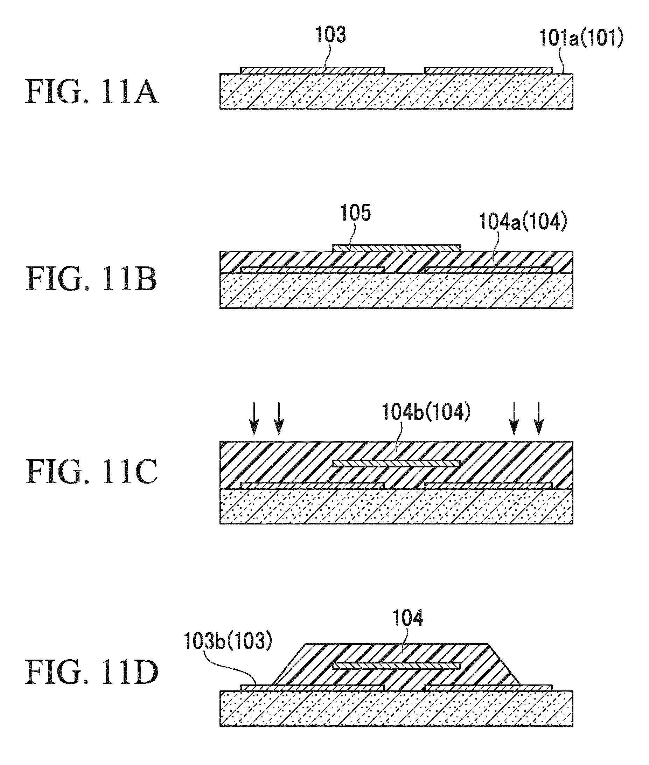

Additionally, a method of manufacturing a coil wiring element used in a conventional magnetic sensor element has the following problems; this method will be described hereinbelow with reference to FIGS. 11D to 11E.

In a conventional method of manufacturing a coil wiring element, firstly, first wiring layers 103 are formed on a substrate 101, subsequently, an insulating layer 104 that covers over center regions of the first wiring layers 103 is formed (FIG. 11D).

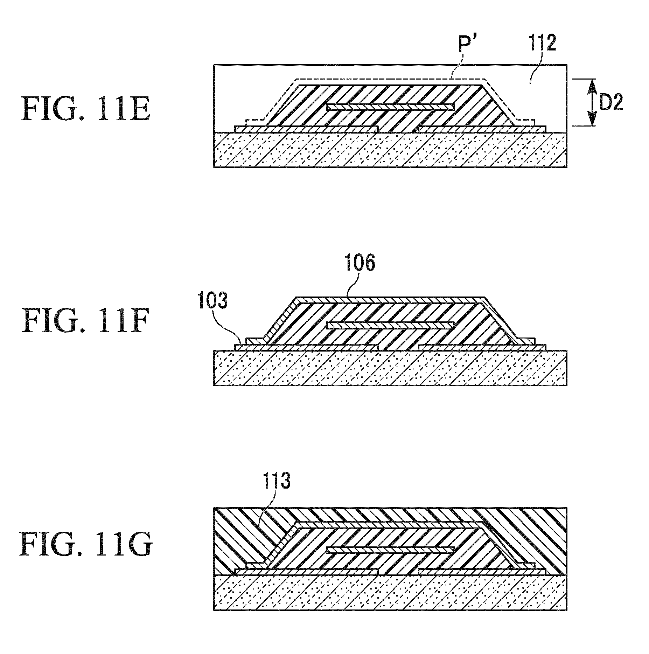

Next, a second wiring layer 106 are formed on the insulating layer 104 and the ends of the first wiring layers 103 are connected to the ends of the second wiring layer 106 (FIG. 11F).

As a technique of forming the second wiring layer 106, a commonly-used photolithographic technique is used.

Specifically, firstly, a resist 112 that coats the first wiring layers 103 and the insulating layer 104 is formed.

Subsequently, the resist layer 112 is exposed by use of a photomask, and the pattern P' of the second wiring layer 106 is thereby transferred to the resist layer 112 (FIG. 11E).

After that, the resist layer 112 is subjected to a development process, and the resist layer 112 on which the pattern P' is formed is formed on the first wiring layers 103 and the insulating layer 104.

Next, by utilizing the resist layer 112 that was processed by patterning, a metal layer having the reverse pattern that is reversed to the pattern of the resist layer 112 is formed.

As a result, the metal layer having the reverse pattern becomes the second wiring layer 106 (FIG. 11F).

When the above-mentioned resist layer 112 is exposed, it is necessary to carry out patterning of the resist layer 112 that is provided on the insulating layer 104 and on the first wiring layers 103 by collectively exposing the resist layer 112 provided on the insulating layer 104 and the resist layer 112 provided on the first wiring layers 103.

However, since there is difference in height between the insulating layer 104 and the first wiring layer 103 (there is difference in level indicated by arrow D2 in FIG. 11E), the distance from an exposure light source to the insulating layer 104 is different from the distance from the exposure light source to the first wiring layer 103 during exposure, that is, the distance from the exposure light source to the portion to be exposed differs depending on the position to be exposed.

Particularly, in the case of using an exposure apparatus in which a depth of focus (focus depth) is shallow, it is difficult to focus on the position on the insulating layer 104 and the position on the first wiring layer 103.

Consequently, processing accuracy of a resist pattern that is formed on the insulating layer 104 is different from that of a resist pattern that is formed on the first wiring layer 103.

For this reason, it is difficult to form a microscopic second wiring layer 106 with a high level of accuracy, as a result, it is difficult to form a high-densely wound coil wiring.

The invention was conceived in view of the above-described circumstances and has an object thereof to provide a coil wiring element having a high level of structural strength and a method of manufacturing a coil wiring element which can reduce a wiring space.

### MEANS FOR SOLVING THE PROBLEMS

A coil wiring element of a first aspect of the invention includes: a plurality of first wirings that are formed above a substrate and have a center portion and both end portions; a second resin portion that is formed above the substrate and support both end portions of each of the first wirings; a first resin portion that covers the center portion of each of the first wirings; a plurality of second wirings that are formed above the first resin portion and have both end portions; connecting portions that connect the first wirings to the second wirings and are supported by the second resin portion; and a coil wiring in which both end portions of the first wirings are connected to both end portions of the second wirings in series, the coil wiring being wound around the first resin portion in a spiral shape.

In the coil wiring element, the second resin portions are provided between the substrate and the connecting portions at which both end portions of the first wiring are connected to end portions of the second wiring.

Because of this, even where stress is applied to the connecting portions, the second resin portion functions as a cushion and reduces stress that is to be applied to the connecting portions.

As a result, the possibility of separation of the first wiring from the second wiring, which constitute the connecting portions, is reduced, and a coil wiring element with a high level of reliability is realized.

In the coil wiring element of the first aspect of the invention, it is preferable that the second resin portion have a side face, and that the first wirings, which are provided at and on the side face be inclined with respect to one surface of the substrate toward a center of the coil wiring.

According to this configuration, the configuration of both end portions of the first wiring can be formed in a tapered shape.

When stress is transmitted from the substrate through the second resin portions at both taper-shaped end portions, both end portions of the first wiring deforms, and it is possible to absorb the stress.

As a result, the possibility of fracture of the first wiring and the second wiring at the connecting portion is reduced, and a coil wiring element with a high level of reliability is realized.

In the coil wiring element of the first aspect of the invention, it is preferable to that a magnetic body be located inside the first resin portion.

According to this configuration, a magnetic sensor element, that is provided with a magnetic body inside the coil wiring serving as a magnetic core, can be realized.

A method of a second aspect of the invention of manufacturing a coil wiring element include: forming a second resin portion on one surface of a substrate (step A); forming a first wiring that is formed above the substrate and has both end portions supported by the second resin portion (step B); forming a first resin portion that covers a center portion of the first wiring (step C); and forming a second wiring, that connects both end portions of the first wiring, above the first resin portion by use of a photolithographic technique patterning resist (step D).

By using the method of the second aspect of the invention manufacturing a coil wiring element, it is possible to manufacture the aforementioned coil wiring element of the first aspect of the invention.

According to the method of manufacturing a coil wiring element, since both end portions of the first wirings are supported by the second resin portion, a difference in level between both end portions of the first wiring and the upper face of the first resin portion (a step-difference between both end portions of the first wiring and the center portion of the second wiring) is reduced relative to a conventional coil wiring element.

Consequently, when the second wiring is formed by photolithography, since the resist pattern can be easily formed so as to bridge the difference in level, it is possible to simply reduce the width of the second wiring that is formed between both end portions of the first wiring and the first resin portion.

### Effects of the Invention

According to the coil wiring element of the first aspect of the invention, the second resin portions are provided between the substrate and the connecting portions at which both end portions of the first wiring are connected to end portions of the second wiring.

Because of this, even where stress is applied to the connecting portions, the second resin portion functions as a cushion and reduces stress that is to be applied to the connecting portions.

As a result, the possibility of separation of the first wiring from the second wiring, which constitute the connecting portions, is reduced, and a coil wiring element with a high level of reliability is realized.

According to the manufacturing method of a coil wiring element of the second aspect of the invention, since both end portions of the first wirings are supported by the second resin portion, a difference in height between both end portions of the first wiring and the upper face of the first resin portion is relieved relative to a conventional coil wiring element.

For this reason, since the resist pattern can be easily formed so as to bridge the difference in height, it is possible to simply reduce the width of the second wiring that is formed between both end portions of the first wiring and the upper face of the first resin portion.

### BRIEF DESCRIPTION OF THE DRAWINGS

FIG. 1 is an exploded perspective view showing a coil wiring element 10 of a first embodiment of the invention.
FIG. 2 is a perspective view showing the coil wiring element 10 of the first embodiment of the invention from above as if the first resin portion 4 was transparent.
FIG. 3 is a schematic cross-sectional view taken along the line X-X shown in FIG. 2.
FIG. 4 is a schematic view showing a conventional coil wiring element 100 which corresponds to a cross section taken along the line X-X shown in FIG. 2.
FIG. 5 is a schematic cross-sectional view taken along the line V-V shown in FIG. 2.
FIG. 6 is a schematic cross-sectional view taken along the line VI-VI shown in FIG. 2.
FIG. 7 is an enlarged view showing a cross-sectional face including a connecting portion W of the coil wiring element 10 of the first embodiment of the invention.
FIG. 8 is an enlarged view showing a cross-sectional face including a connecting portion of a conventional coil wiring element 100.
FIG. 9 is a schematic cross-sectional view taken along the line VII-VII shown in FIG. 2.
FIG. 10A is a cross-sectional view illustrating a method of manufacturing the coil wiring element 10 of the embodiment of the invention.
FIG. 10B is a cross-sectional view illustrating the method of manufacturing the coil wiring element 10 of the embodiment of the invention.
FIG. 10C is a cross-sectional view illustrating the method of manufacturing the coil wiring element 10 of the embodiment of the invention.
FIG. 10D is a cross-sectional view illustrating the method of manufacturing the coil wiring element 10 of the embodiment of the invention.
FIG. 10E is a cross-sectional view illustrating the method of manufacturing the coil wiring element 10 of the embodiment of the invention.
FIG. 10F is a cross-sectional view illustrating the method of manufacturing the coil wiring element 10 of the embodiment of the invention.
FIG. 10G is a cross-sectional view illustrating the method of manufacturing the coil wiring element 10 of the embodiment of the invention.
FIG. 10H is a cross-sectional view illustrating the method of manufacturing the coil wiring element 10 of the embodiment of the invention.
FIG. 10I is a cross-sectional view illustrating the method of manufacturing the coil wiring element 10 of the embodiment of the invention.
FIG. 11A is a cross-sectional view illustrating a method of manufacturing a conventional coil wiring element 100.
FIG. 11B is a cross-sectional view illustrating the method of manufacturing the conventional coil wiring element 100.
FIG. 11C is a cross-sectional view illustrating the method of manufacturing the conventional coil wiring element 100.
FIG. 11D is a cross-sectional view illustrating the method of manufacturing the conventional coil wiring element 100.
FIG. 11E is a cross-sectional view illustrating the method of manufacturing the conventional coil wiring element 100.
FIG. 11F is a cross-sectional view illustrating the method of manufacturing the conventional coil wiring element 100.
FIG. 11G is a cross-sectional view illustrating the method of manufacturing the conventional coil wiring element 100.

### EMBODIMENTS FOR CARRYING OUT THE INVENTION

Hereinafter, the invention will be described based on a preferred embodiment with reference to drawings.

### <Coil Wiring Element>

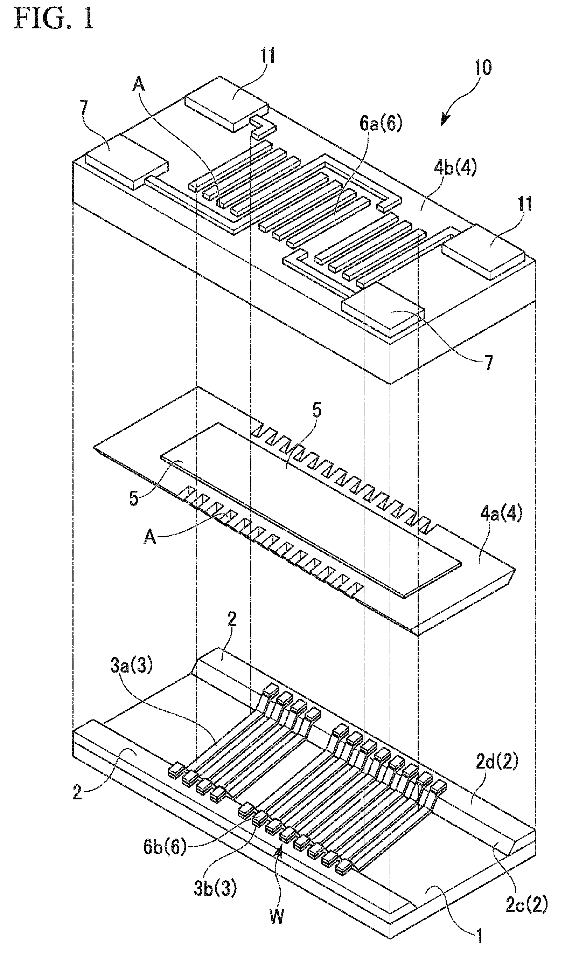

FIG. 1 is an exploded perspective view showing a coil wiring element 10 of a first embodiment of the invention.

In the exploded perspective view, an element group that is constituted of a substrate 1, a second resin portion 2, and first wirings 3, an element group that is constituted of a first portion 4a of a first resin portion 4 (a part of the first resin portion 4) and a magnetic body (magnetic core) 5, and an element group that is constituted of a second portion 4b of the first resin portion 4 (the other portion of the first resin portion 4) and second wirings 6 are divided and these groups are shown so as to be separated from each other.

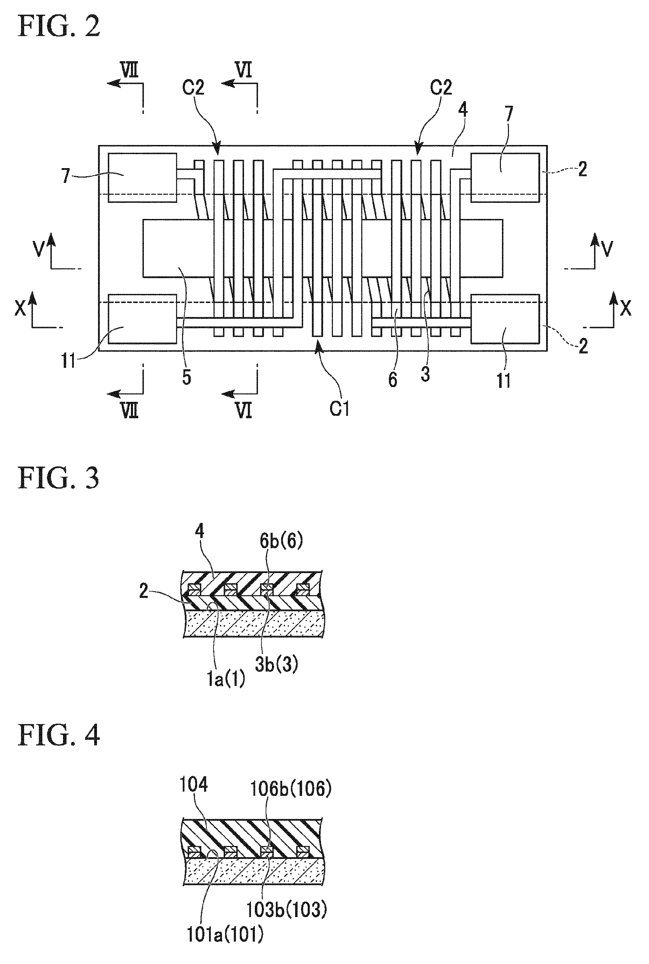

FIG. 2 is a perspective view from above as if the first resin portion 4 was transparent.

The coil wiring element 10 includes: a plurality of the first wiring 3 (lower wiring) formed on the substrate 1; the second resin portion 2 that is formed on the substrate 1 and supports the end 3b of each first wiring 3; the first resin portion 4 that covers a center portion 3a of wiring of each first wiring 3; and a plurality of the second wirings 6 (upper wiring) formed above the first resin portion 4.

Both end portions 3b of the first wirings 3 are connected to both end portions 6b of a plurality of second wirings 6 in series such that both end portions 3b of each first wiring 3 correspond to both end portions 6b of each second wiring 6, accordingly, the coil wiring element 10 is provided with a coil wiring that is wound around the first resin portion 4 in a spiral shape.

The connecting portions W at which the first wirings 3 are connected to the second wirings 6 are supported by the second resin portion 2.

More specifically, as shown in FIG. 1, two second resin portions 2 are provided on the substrate 1 so as to be located at both sides of the substrate 1.

A first end 3b of the first wiring 3 (both end portions 3b, lower end portion) is connected to a first end 6b of the second wiring 6 (both end portions 6b, upper end portion) at one of the second resin portions 2.

A second end 3b of the first wiring 3 (both end portions 3b, lower end portion) is connected to a second end 6b of the second wiring 6 (both end portions 6b, upper end portion) at the other of the second resin portions 2.

In the explanation described below, a connection structure will be described in which both end portions 3b of the first wiring 3 are connected to both end portions 6b of the second wiring 6.

The connection structure in which the first end 3b of the first wiring 3 is connected to the first end 6b of the second wiring 6 and the second end 3b of the first wiring 3 is connected to the second end 6b of the second wiring 6 means that both end portions 3b are connected to both end portions 6b.

Additionally, in the explanation described below, the first end or the second end which constitutes both end portions may be referred to as an end portion.

As shown in FIG. 1, both end portions 3b of the first wiring 3 are formed to extend to the above second resin portion 2 and are supported by the second resin portion 2.

The second resin portions 2 are interposed between the substrate 1 and both end portions 3b of the first wirings 3 and support both end portions 3b from the substrate 1.

Both end portions 6b of the second wiring 6 are formed extend to both above end portions 3b of the first wiring 3.

Furthermore, both end portions 3b of the first wiring 3 are connected to both end portions 6b of the second wiring 6 above the second resin portions 2.

Consequently, the connecting portions W at which both end portions 3b of the first wiring 3 are connected to both end portions of the second wiring 6 are supported by the second resin portions 2.

Due to connection of both end portions 3b of the first wirings 3 to both end portions 6b of the second wirings 6 in series, the first wirings 3 and the second wirings 6 are connected in series, and coil wirings C1 and C2 that are wound around the first resin portion 4 in a spiral shape are thereby formed.

In the embodiment, the coil wiring element 10 includes two coil wirings C1 and C2.

This configuration is easy to understand with reference to FIG. 2.

A first coil wiring C1 is wound around the center region of the magnetic core 5.

Both ends of the first coil wiring C1 are connected to two electrode pads 11 that are provided on the upper surface of the first resin portion 4.

Second coil wirings C2 are wound around the magnetic core 5 so as to sandwich both sides of the first coil wiring C1.

Moreover, the second coil wirings C2 that are located at both sides of the first coil wiring C1 are connected to each other in series.

Both ends of the second wirings C2 are connected to two electrode pads 7 that are provided on the upper surface of the first resin portion 4.

With this configuration, the first coil wiring C1 functions as a pick-up coil and the second coil wirings C2 functions as an excitation coil, therefore, it is possible to allow the coil wiring element 10 to function as a flux-gate magnetic sensor element.

Particularly, the number of windings or a wiring pattern of the first coil wiring C 1 and the second coil wiring C2 are appropriately adjusted by a well-known method such as photolithography during manufacturing the coil wiring element 10.

Both end portions 3b of the first wiring 3 are connected to both end portions 6b of the second wiring 6 in series on the second resin portions 2, therefore, both the first coil wiring C1 and the second coil wiring C2 are thereby wound around the first resin portion 4 in a spiral shape.

Each coil wiring has the same basic structure and is simply referred to as the "coil wiring C" without discriminating each of the coil wirings in this description unless otherwise stated.

Hereinafter, a configuration of the coil wiring C of the embodiment will be described in more detail.

As shown in FIGS. 1 and 2, the first wirings 3 having the same length are disposed substantially parallel to each other at equal intervals on one surface of the substrate 1 (first surface, a surface on which the second resin portion 2 is formed).

Both end portions 3b of the first wirings 3 are formed on a side face 2c of the second resin portion 2 provided on the substrate 1 so as to extend toward an upper face 2d of the second resin portion 2 and is furthermore provided so as to be mounted on the upper face 2d of the second resin portion 2.

On the upper face 2d of the second resin portion 2, both end portions 3b of the first wiring 3 are connected to both end portions 6b of the second wiring 6 which are provided so as to come down from above.

Consequently, both end portions 3b of the first wiring 3 and both end portions 6b of the second wiring 6 are supported by the second resin portion 2.

Since the second resin portion 2 is not disposed under the center portions 3a of the first wirings 3, the center portions 3a of the first wirings 3 is in contact with one surface of the substrate 1.

Particularly, since the substrate 1 of the embodiment is made of a silicon substrate, an insulating film such as SiO₂ or SiN is formed on the surface thereof.

In this description, the insulating film is part of the substrate 1.

Center portions 6a of the second wirings 6 having the same length are disposed substantially parallel to each other at equal intervals on the second portion 4b of the first resin portion 4.

Both end portions 6b of the second wirings 6 are disposed on and connected to both end portions 3b of the first wirings 3 that are disposed on the upper face 2d of the second resin portion 2.

FIG. 3 is a schematic cross-sectional view taken along the line X-X shown in FIG. 2.

The second resin portion 2 is disposed on one surface 1a of the substrate 1.

Both end portions 3b of the first wiring 3 and both end portions 6b of the second wiring 6 are stacked on the second resin portion 2 in order, and both end portions 3b are connected to both end portions 6b.

In the coil wiring C, a portion at which both end portions 3b are connected to both end portions 6b is referred to as a connecting portion W.

The second resin portion 2 is disposed between both end portions 3b of the first wiring 3 and the substrate 1.

The second resin portion 2 supports the connecting portion W at which both end portions of the first wiring 3 and both end portions 6b of the second wiring 6 are stacked in layers.

FIG. 4 is a schematic view showing a conventional coil wiring element 100 which corresponds to a cross section taken along the line X-X shown in FIG. 2.

Both end portions 103b of a first wiring 103 and both end portions 106b of a second wiring 106 are stacked on one surface 101 a of the substrate 101 in order, and both end portions 103b are connected to both end portions 106b.

Both end portions 103b of the first wiring 103 are in contact with one surface 101a of the substrate 101.

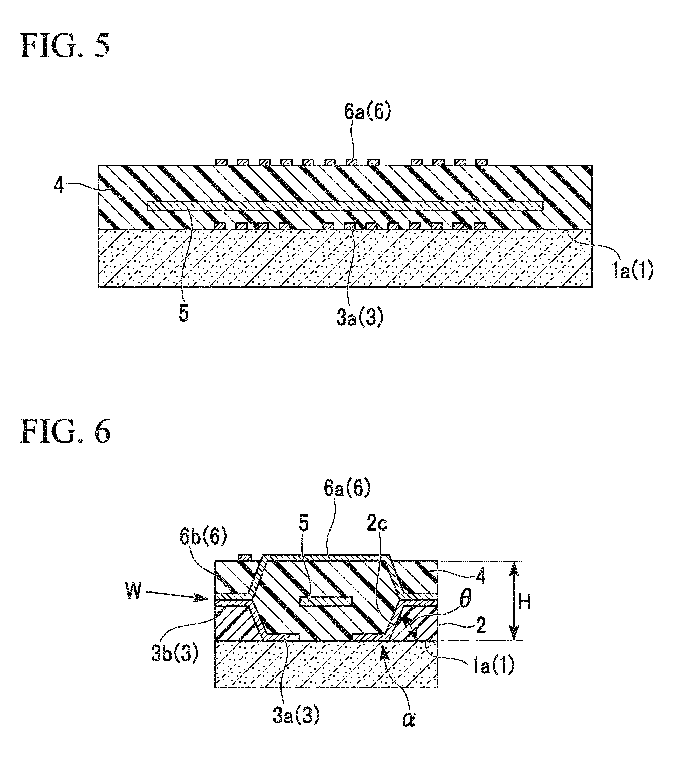

FIG. 5 is a schematic cross-sectional view taken along the line V-V shown in FIG. 2.

The center portions 3 a of the first wirings 3, the first resin portion 4, and the center portions 6a of the second wirings 6 are disposed on one surface 1a of the substrate 1 in order.

Furthermore, the magnetic core 5 is provided between the first wiring 3 and the second wiring 6, and the magnetic core 5 is located at the central portion of the coil wiring C.

That is, a magnetic body (magnetic core 5) is located inside the first resin portion 4.

Accordingly, the coil wiring element 10 of the embodiment functions as a magnetic sensor element that detects variation in magnetic flux that is magnetically collected in the magnetic core 5.

FIG. 6 is a schematic cross-sectional view taken along the line VI-VI shown in FIG. 2.

Two side faces 2c of the second resin portion 2 that face each other are inclined with respect to one surface 1a of the substrate 1 so as to sandwich the center portions 3 a of the first wirings 3.

This means that, two side face 2c have a shape that is tapered with respect to one surface 1a.

An angle 0 formed between the side face 2c and one surface 1a of the substrate 1 is approximately 60 degrees.

A bend angle (an angle of the first inclined wiring with respect to one surface 1a of the substrate 1) of the first wiring 3 (first inclined wiring) provided on the side face 2c is the same as an angle θ formed between the side face 2c and the surface 1a.

In the first embodiment of the invention, the height of the second resin portion 2 (thickness, distance from the surface 1a to the upper face 2d) is not particularly limited, is preferably 1/10 to 9/10 of the distance H from one surface 1 a of the substrate 1 to the center portion 6a of the second wiring 6, more preferably 1/4 to 3/4 thereof, additionally, more preferably 1/3 to 2/3 thereof.

In the case where the height of the second resin portion 2 is in the aforementioned range, both end portions 3b of the first wiring 3 can be sufficiently separated from the substrate 1 with the second resin portion 2 interposed therebetween, and stress to be applied to the connecting portion W can be further reduced.

In the first embodiment of the invention, an angle θ formed between the side face 2c and the surface 1a and the bend angle of the first wiring 3 provided on the side face 2c are not particularly limited, for example, are preferably, 10 to 80 degrees, more preferably 20 to 70 degrees, and most preferably 30 to 60 degrees.

In the embodiment, the angle θ formed between the side face 2c and the surface 1a is 60 degrees.

In the case where the angle 0 formed between the side face 2c and the surface 1 a is in the aforementioned range, the first wiring 3 gradually bends at the bend portion α of the first wiring 3 as compared with in the case of 90 degrees.

For this reason, a strength of structure between the bend portion α of the first wiring 3 and the connecting portions W increases.

That is, even in a case where the substrate 1 deforms and stress is applied to the bend portion α of the first wiring 3, since the bend portion α can easily deform following deformation of the substrate, it is possible to prevent the first wiring 3 from being fractured at the bend portion α or prevent the connecting portion W from being delaminated and breaking.

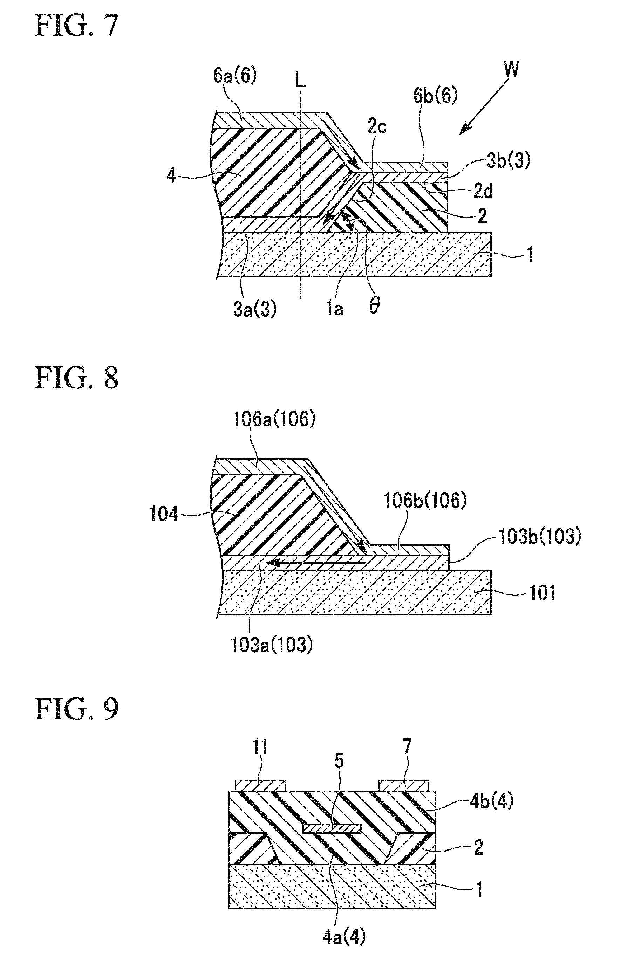

FIG. 7 shows an enlarged cross section including the connecting portion W.

In the coil wiring element 10 related to the first embodiment of the invention, the side face 2c of the second resin portion 2 and the first wiring 3 (first inclined wiring) provided on the side face 2c are inclined with respect to one surface 1a of the substrate 1 so as to extend toward the center of coil wiring C.

In other words, the side face 2c of the second resin portion 2 and the first inclined wiring of the first wiring 3 provided on the side face 2c are inclined in the direction that is inclined with respect to the straight line L orthogonal to the central axis of the coil wiring C (here, the straight line L is the perpendicular line of one surface 1 a of the substrate 1).

Here, angles of the side face 2c of the second resin portion 2 and the first inclined wiring of the first wiring 3 provided on the side face 2c with respect to one surface 1a of the substrate 1 are represented as θ.

As a result, an interconnection length of the coil wiring C in one roll in the coil wiring element 10 is shorter than that of a conventional coil wiring.

A specific explanation will be provided below.

In the coil wiring C related to the first embodiment of the invention, a wiring (second inclined wiring, end portion 6b) that comes down to the connecting portion W along the inclined surface of the first resin portion 4 from the center portion 6a of the second wiring 6 is connected to the end portion 3b of the first wiring 3 on the upper face 2d of the second resin portion 2 before reaches the substrate 1.

Consequently, the coil wiring C is bended toward the center thereof at the connecting portion W in the pathway of the coil wiring C formed by the first wiring 3 and the second wiring 6, and the coil wiring C comes down to the center portion 3a of the first wiring 3.

In the pathway (the pathway indicated by an arrow in FIG. 7), since the direction in which the wiring is inclined changes at the connecting portion W, the wiring pathway thereof is shorter than the wiring structure in which an inclination direction is not changed, and therefore the entire length of an interconnection length (path length) becomes short.

Furthermore, as the number of windings of coil wiring increases, the entire interconnection length thereof becomes significantly shorter than that of a conventional coil wiring.

As a result of shortening the interconnection length, generation of Joule heat due to an electrical current flowing in a coil wiring can be reduced.

FIG. 8 shows an enlarged cross section including a connecting portion of a conventional coil wiring element 100.

A wiring (both end portions 106b) is formed so as to come down to a connecting portion from the center portion 106a of the second wiring 106 reaches the substrate 1, so as to be connected to both end portions 103b of the first wiring 103, and so as to fold back toward the center of the coil wiring element 100 along the top surface of the substrate 1.

In the pathway (the pathway indicated by an arrow in FIG. 8), since an inclined wiring portion (end portion 106b) of the second wiring 106 extends in a direction away from the center of the coil wiring and is a roundabout wiring pathway, and therefore the entire length of an interconnection length (path length) becomes long.

FIG. 9 is a schematic cross-sectional view taken along the line VII-VII shown in FIG. 2.

The magnetic core 5 is located inside the first resin portion 4.

The first portion 4a of the first resin portion 4 is sandwiched between opposed two second resin portions 2.

In the embodiment, since the electrodes 11 and the electrodes 7 which are connected to the coil wiring C (solenoidal coil) are provided on the first resin portion 4, it is necessary to form opening portions that ensures the electrical continuity of such electrodes 7 and 11.

In other cases, a protection resin portion (not shown in the figure) may be optionally formed at a desired portion on the first resin portion 4 and the second wiring 6.

By protecting the second wiring 6 serving as an upper wiring of the coil wiring C, it is possible to prevent the coil wiring C from being adversely affected from the outside thereof.

The protection resin layer may be formed of resins such as polyimide, polybenzoxazole, silicone.

In particular, as shown in FIG. 1, opening portions A are formed around the connecting portions W on the first resin portion 4, however, the opening portion A are not necessarily formed therearound.

A peripheral shape of the connecting portion W of the first resin portion 4 is not particularly limited as long as the shape of the first resin portion 4 does not interfere with connection between both end portions 3b of the first wiring 3 and both end portions 6b of the second wiring 6.

In the invention, a material used to form the substrate 1 is not particularly limited, for example, semiconductor such as silicon, glass such as silica glass, ceramics, plastic (resin), or the like is used.

Additionally, a hard printed board or a flexible printed board may be adopted.

A thickness of the substrate 1 is not particularly limited.

In the case of using the coil wiring element 10 as a magnetic sensor element, the substrate 1 is preferably a non-magnetic body.

Constituent materials used to form the coil wiring C, an electroconductive layer 8, and a conductor 9 are not particularly limited, a metal such as copper (Cu), gold (Au) which is used as general wiring is used.

Furthermore, constituent materials used to form the electrode pads 7 and 11 used for the coil wiring C are not particularly limited, general materials such as aluminum or germanium may be adopted.

A wiring width of the coil wiring C may be, for example, 1.0 to 5.0 µm.

The number of windings of the coil wiring C is appropriately set depending on the intended use of a coil wiring element.

In the case where the intended use of the coil wiring C is use of a magnetic sensor element, as the number of windings increases, the sensor sensitivity thereof becomes higher; therefore, as the number of windings increases, it is more preferable; for example, the number of windings may be 30 to 200 turns by adjusting a size of the coil wiring element, a line width of the coil wiring, or a distance between wirings.

Furthermore, an interconnection length of the coil wiring C may be, for example, 400 to 1600 µm.

A distance H from one surface 1a of the substrate 1 to the center portion 6a of the second wiring 6 is not particularly limited and may be, for example, 5 to 25 µm.

Moreover, a distance between the opposed second resin portions 2 (distance between the side faces 2c of the second resin portion 2 facing each other) is not particularly limited and may be, for example, 100 to 300 µm.

A structure in which the magnetic core 5 is located inside the first resin portion 4 of the coil wiring element 10 is adopted in the embodiment.

In the case of using the coil wiring element related to the embodiment of the invention as a magnetic sensor element, a configuration of the magnetic body that is disposed inside the coil wiring C is not particularly limited, and a magnetic core having a known configuration is used.

As the magnetic core 5, a configuration having a thin film made of a soft magnetic material to which uniaxial anisotropy is imparted is preferably used.

As the soft magnetic body, a zero magnetostrictive Co-series amorphous film as typified by CoNbZr or CoTaZr, a NiFe alloy, a CoFe alloy, or the like is preferably used.

A thickness of the magnetic core 5 may be, for example, 0.5 to 2.0 µm.

### <Method of Manufacturing Coil Wiring Element>

A method of the invention of manufacturing a coil wiring element will be described using the above-mentioned coil wiring element 10 as an example.

### (Step A)

In the step A, the second resin portion 2 is provided on one surface 1a of the substrate 1.

As the substrate 1, a glass substrate, a ceramic substrate, a rigid substrate made of resin, a flexible printed board, or the like may be adopted.

Firstly, an insulating film made of SiO₂ is formed on one surface 1a of a silicon substrate 1 using a CVD method or the like.

Alternatively, a silicon substrate on which an insulating film made of SiO₂ has been already formed may be used.

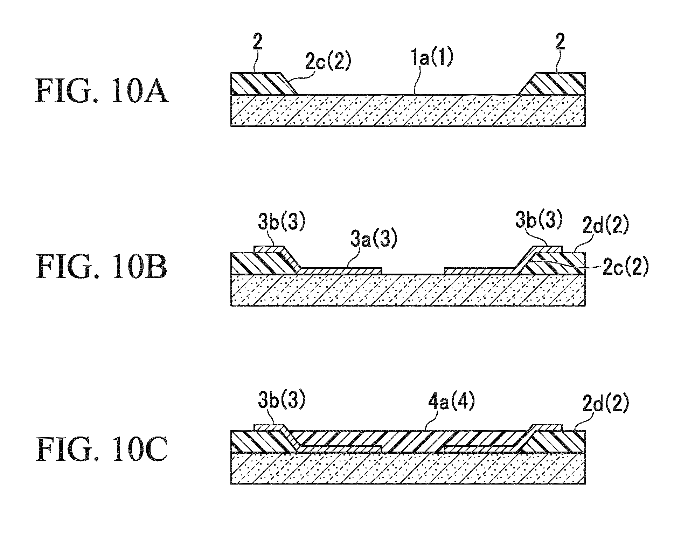

Next, a photosensitive resin such as polyimide is applied on that using a spin coating method or the like, and a second resin portion 2 that is patterned by photolithography is formed (FIG. 10A).

Subsequently, the second resin portion 2 is subjected to baking and is thermally cured.

The side face 2c can be inclined so as to adjust the angle θ formed between the side face 2c of the second resin portion 2 and one surface 1a.

As the method of adjusting the angle θ, known methods such as a method of adjusting the baking time, a method of adjusting an exposure amount or a developing time during photolithography, or a method of adjusting a thickness of the second resin portion 2 are used.

Specific conditions are suitably adjusted depending on a material used to form the second resin portion.

### (Step B)

In the step B, the first wirings 3 are provided so that the center portions 3 a of the first wirings 3 are formed on one surface 1a of the substrate 1 and both end portions 3b of the first wirings 3 are disposed on the second resin portion 2, particularly, so that the end portions 3b are formed on the upper face 2d of the second resin portion 2 and the first inclined wirings are formed on the side face 2c.

A barrier metal layer such as Ti, Cr, or TiW is formed on one surface 1a of the substrate 1 that is obtained in the step A, on the side face 2c of the second resin portion 2, and on the upper face 2d of the second resin portion 2 by use of a sputtering method, and furthermore Cu is formed thereon by sputtering.

Subsequently, a resist pattern corresponding to the pattern of the first wiring 3 is formed using photolithography (not shown in the figure), and a wiring pattern is formed using wet etching (FIG. 10B).

As a different method of forming a wiring pattern, a sputtered film is used as a seed layer, and the first wirings 3 may be formed by use of an electrolytic plating method.

A thickness of the first wiring 3 is not particularly limited. If an irregularity that is caused by the first wirings 3 appears at the location of a subsequently-formed magnetic core 5, there is a concern that a function of the magnetic core 5 is adversely affected.

In order to avoid this, a thickness of the first wiring 3 may be, for example, 0.2 to 2 µm.

### (Step C)

In the step C, the first resin portion 4 is provided on the first wiring 3.

Here, a method of separately forming the first portion 4a and the second portion 4b so as to form the first resin portion 4 will be described as an example.

A photosensitive resin is applied on the center portions 3a of the first wirings 3 so as to fill a gap between the first wirings 3 by use of a spin coating method or the like and is thermally-cured, and the first portion 4a of the first resin portion 4 is thereby formed (FIG. 10C).

In the embodiment, the first portion 4a is formed so that a thickness of the first portion 4a of the first resin portion 4 is the same as the thickness of the second resin portion 2 and so that both end portions 3b of the first wiring 3 are not covered with the first portion 4a of the first resin portion 4.

However, it is not necessarily to form the first portion 4a so as to have such thickness.

It is only necessary to set the thickness of the first portion 4a to be the extent that the irregular of the center portions 3 a of the first wirings 3 does not appear at the top surface of the first portion 4a of the first resin portion 4, and the thickness may be, for example, twice or more the thickness of the first wiring 3.

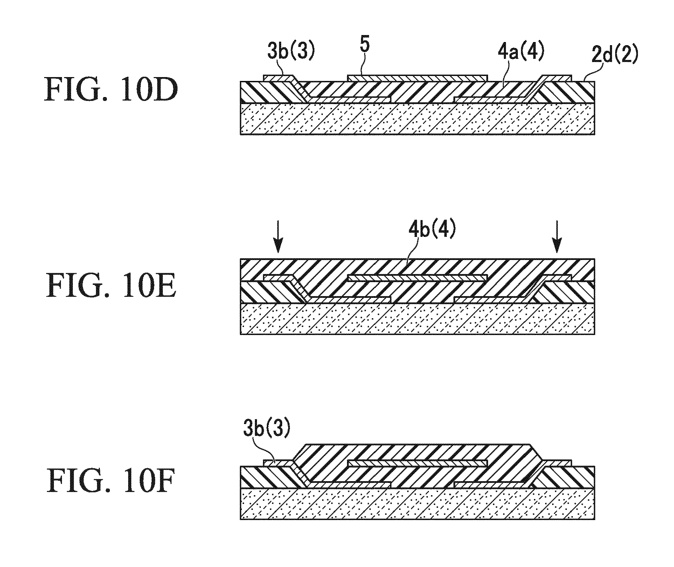

Next, a soft-magnetic film that becomes a magnetic core 5 is formed on the first portion 4a using a sputtering method, and the magnetic core 5 is patterned by use of photolithography etching so as to have a desired shape (FIG. 10D).

In the case where a constituent material of the soft-magnetic film is a metal such that it is relatively difficult to etch the metal, such as a Co-series amorphous film, a NiFe alloy, or a CoFe alloy, a lift-off technology is used in which a resist is formed, thereafter, the soft-magnetic film is formed by sputtering after, and a desired pattern is formed by removing the resist.

Furthermore, a NiFe alloy or a CoFe alloy which serves as a magnetic core 5 having a desired shape can be formed by use of a electrolytic plating method using a resist frame.

After the soft-magnetic film that becomes a magnetic core 5 is formed, it is preferable that a heat treatment in a rotating magnetic field or a heat treatment in a static magnetic field, which removes non-uniform uniaxial anisotropy imparted during film formation therefrom and imparts uniform induced magnetic anisotropy thereto, be carried out.

Subsequently, a photosensitive resin is applied on the magnetic core 5, the first portion 4a of the first resin portion 4, both end portions 3b of the first wiring 3, and the upper face 2d of the second resin portion 2 by use of a spin coating method or the like (FIG. 10E).

Thereafter, patterning is carried out using a photolithographic technique, thermal curing is carried out, and the second portion 4b of the first resin portion 4 is thereby formed (FIG. 10F).

The arrow shown in FIG. 10E represents exposure using ultraviolet light which is used to expose the photosensitive resin.

In the exposure, a desired region can only be exposed by use of a photomask.

A thickness of the second portion 4b of the first resin portion 4 is not particularly limited.

The distance H between the center portion 6a of the second wiring 6 which are subsequently formed on the first resin portion 4 and one surface 1a of the substrate 1 can be controlled by adjusting the thickness.

The magnetic core 5 is formed to allow the coil wiring element 10 to function as a magnetic sensor element in the embodiment; however, in the case of using the coil wiring element 10 for other use, it is not necessary to form the magnetic core 5.

In this case, since it is not necessary to separately form the first portion 4a and the second portion 4b so as to form the first resin portion 4, it is only necessary to form the first resin portion 4 having a desired thickness after the formation of the first wiring 3.

### (Step D)

In the step D, the second wirings 6 that are connected to both end portions 3b of the first wirings 3 are formed on the first resin portion 4.

In the step D, a resist layer 12 coating the first wiring 3 and the first resin portion 4 are formed and the resist layer 12 is patterned by use of a photolithographic technique.

Subsequently, by use of the patterned resist layer 12, it is possible to form the second wirings 6 having a reverse pattern on which the pattern of the resist layer 12 is reversed.

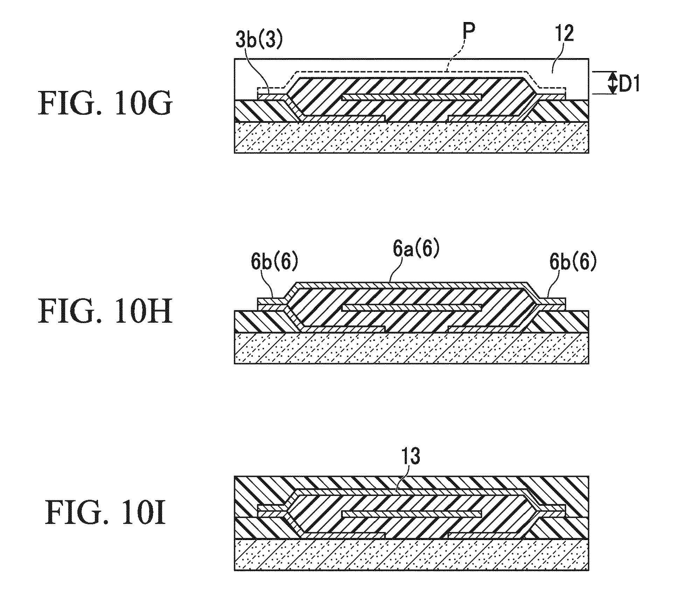

A photolithographic technique of forming the second wirings 6 will be particularly described in detail with reference to FIG. 10G.

Firstly, the resist layer 12 is formed on a region on which the second wirings 6 are to be formed, the resist layer 12 is exposed by use of a photomask, thereafter, the exposed resist layer 12 is subjected to development, and a pattern P corresponding to the second wirings 6 is thereby formed.

The upper surface of the first resin portion 4 is exposed at a bottom portion of the pattern P, and furthermore both end portions 3b of the first wirings 3 are exposed thereat.

In the case where the pattern P corresponding to the second wirings 6 is formed in the resist layer 12, the pattern of the resist layer 12 is the reverse pattern of the second wirings 6.

Regarding the exposure of forming the pattern P, it is necessary to expose the resist in the depths of the upper surface of the first resin portion 4 and both end portions 3b of the first wiring 3.

A difference in level between the upper surface of the first resin portion 4 and both end portions 3b of the first wiring 3 is represented as D1.

Here, the difference D1 in level in the exposure is referred to as a focus depth.

In themanufacturing method of the invention, since the second resin portion 2 is formed, the step-difference D1 is shorter than that of a conventional coil wiring, and a required focus depth is relatively shallow.

Therefore, it is possible to reduce a width of the pattern P which is shorter than that of a conventional coil wiring.

Next, the second wirings 6 are formed by use of the pattern P.

For example, a barrier metal layer such as Ti, Cr, or TiW is formed on both end portions 3b of the first wiring 3 and the upper surface of the first resin 4 which are exposed at a bottom surface of the pattern P by use of a sputtering method or the like.

Subsequently, after Cu is formed using an electrolytic plating method or the like using Cu, the second wiring 6 having the pattern P can be formed by removing the resist layer 12.

At this time, both end portions 6b of the second wiring 6 are sequentially connected to both end portions 3b of the first wiring 3, and a coil wiring C that is wound around the first resin portion 4 is thereby formed (FIG. 10H).

Here, the case of using a sputtering method and an electrolytic plating method by use of Cu is described above; in other cases, a known metal film formation method can be similarly adopted.

As stated above, the pattern P corresponding to the second wirings 6 is formed by use of the resist layer 12, and it is possible to form the second wirings 6 by use of a photolithographic technique using the pattern P.

In the coil wiring element manufacturing method related to the embodiment of the invention, since both end portions 3b of the first wiring 3 are formed on the second resin portion 2, a difference in height between the first wiring 3 and the first resin portion 4 is relatively small.

Accordingly, a microscopic resist pattern can be easily formed on the first wiring 3 and on the first resin portion 4 by use of a photolithographic technique.

As a result, microscopic second wirings 6 can be easily formed between the first wiring 3 and the first resin portion 4.

Finally, after the second wirings 6 are formed, a protection resin porion 13 that coats the second wirings 6 are formed if required (FIG. 10I).

### <Method of Manufacturing Conventional Coil wiring>

As a method of manufacturing a conventional coil wiring, a method of manufacturing a conventional coil wiring element 100 will be described below.

Firstly, an insulating film made of SiO2 is formed on one surface 101a of a silicon substrate 100 using a CVD method or the like (not shown in the figure).

Next, a barrier metal layer such as Ti, Cr, or TiW is formed using a sputtering method, and furthermore Cu is formed thereon by sputtering.

Subsequently, a resist pattern corresponding to the pattern of the first wiring 103 is formed using photolithography (not shown in the figure), and a wiring pattern is formed using wet etching (FIG. 11A).

A photosensitive resin is applied to fill a gap between the first wiring layers 103 by use of a spin coating method or the like and is thermally-cured, and the first portion 104a of the first resin portion 104 is thereby formed.

Furthermore, a soft-magnetic film that becomes a magnetic core 105 is formed using a sputtering method and is patterned to have a desired shape by use of photolithography and etching or a lift-off technology using a resist (FIG. 11B).

Subsequently, a photosensitive resin is applied on the magnetic core 105 and on the first portion 104a of the insulating layer 104 by a spin coating method or the like and is thermally cured, and the second portion 104b of the insulating layer 104 is thereby formed (FIG. 11C).

Next, one surface side 101a of the substrate 101 is exposed to ultraviolet light by using a photomask, and at least part of both end portions 103b of a plurality of first wiring layers 103 that are arranged on one surface 101a is exposed (FIG. 11D).

Particularly, the arrow indicated in FIG. 11C represents irradiation light.

Subsequently, the resist layer 112 is formed on a region on which the second wiring layers 106 are to be formed, the resist layer 112 is exposed by use of a photomask, threreafter, development is carried out, and a pattern P' corresponding to the second wiring layer 106 is thereby formed.

The upper surface of the insulating layer 104 is exposed at a bottom portion of the pattern P', and furthermore both end portions 103b of the first wiring layers 103 are exposed thereat.

In the case where the pattern P' corresponding to the second wiring layer 106 is formed in the resist layer 112, the pattern of the resist layer 112 is the reverse pattern of the second wiring layer 106.

Regarding the exposure of forming the pattern P', it is necessary to expose the resist in the depths of the upper surface of the first resin portion 104 and both end portions 103b of the first wiring 103.

A difference in level between the upper surface of the insulating layer 104 and both end portions 103b of the first wiring layers 103 is represented as D2.

Here, the difference D2 in level in the exposure is referred to as a focus depth.

In a conventional manufacturing method, the difference D2 in level is large, and a required focus depth is relatively deep.

Therefore, it is difficult to reduce a width of the pattern P'.

Next, the second wiring layer 106 is formed by use of the pattern P'.

After Cu is formed using, for example, an electrolytic plating method or the like using Cu, the second wiring layer 106 having the pattern P' is formed by removing the resist layer 112, and a coil wiring (solenoidal coil) that is wound around the insulating layer 104 in a spiral shape is formed (FIG. 11F).

Finally, a protection resin porion 113 is formed if required (FIG. 11G).

Accroding to the above-described conventional manufacturing method, since both end portions 103b of the first wiring layers 103 are formed on one surface 101a of the substrate 101, the focus depth D2 is relatively deep.

Because of this, in the case of using the resist layer 112, it is difficult to carry out microfabrication of the second wiring layer 106 with a high level of accuracy.

In the case of reducing the first portion 104a of the insulating layer 104 in thickness in order to reduce the focus depth D2, processing accuracy is improved, however, irregularity that is caused by the first wiring layers 103 appears at the upper surface of the first portion 104a of the insulating layer 104, there is a concern that a function of the magnetic core 105 is adversely affected.

In addition, if the second portion 104b of the insulating layer 104 is reduced in thickness, the magnetic core 105 is displaced from the center of the coil wiring and is excessively close to the second wiring layer 106 (upper wiring), and therefore, there is a possibility that a problem occurs in a function of a magnetic sensor element.

Accordingly, in the case where the coil wiring element 100 is a magnetic sensor element including the magnetic core 105, it is practically impossible to make the focus depth D2 equal to the above-mentioned focus depth D1 as a result of reducing a thickness of the insulating layer 104.

### Industrial Applicability

The present invention is widely available to magnetic sensor elements.

## Claims

1. A coil wiring element comprising:
a plurality of first wirings that are formed above a substrate and have a center portion and both end portions;
a second resin portion that is formed above the substrate and support both end portions of each of the first wirings;
a first resin portion that covers the center portion of each of the first wirings;
a plurality of second wirings that are formed above the first resin portion and have both end portions;
connecting portions that connect the first wirings to the second wirings and are supported by the second resin portion; and
a coil wiring in which both end portions of the first wirings are connected to both end portions of the second wirings in series, the coil wiring being wound around the first resin portion in a spiral shape.

2. The coil wiring element according to claim 1, wherein
the second resin portion has a side face, and
the first wirings, which are provided at and on the side face, are inclined with respect to one surface of the substrate toward a center of the coil wiring.

3. The coil wiring element according to claim 1 or claim 2, wherein
a magnetic body is located inside the first resin portion.

4. A method of manufacturing a coil wiring element, comprising:
forming a second resin portion on one surface of a substrate;
forming a first wiring that is formed above the substrate and has both end portions supported by the second resin portion;
forming a first resin portion that covers a center portion of the first wiring; and
forming a second wiring, that connects both end portions of the first wiring, above the first resin portion by use of a photolithographic technique patterning resist.
